# EUROPEAN PATENT APPLICATION

(11) **EP 3 637 548 A1**
(43) Date of publication of application: **15.04.2020**
(21) Application number: 18808798.5
(22) Date of filing: 25.05.2018
(51) Int. Cl.: H01Q 13/08, H01Q 13/10, H01Q 21/06, H01Q 23/00

(54) **PLANAR ARRAY ANTENNA AND WIRELESS COMMUNICATION MODULE**

(30) Priority: 30.05.2017 JP 2017106692
(71) Applicant: Hitachi Metals, Ltd., Tokyo 108-8224 (JP)
(72) Inventor: TAKAKI Yasunori, Tokyo 108-8224 (JP)
(74) Representative: Wu, Sau Ming Samuel
(86) International application number: PCT/JP2018/020143
(87) International publication number: WO 2018/221403

(57) **Abstract**

A planar array antenna is provided which can be used in broader bands. The planar array antenna includes a plurality of unit cells **50** which are one-dimensionally or two-dimensionally arranged. Each of the unit cells **50** includes a radiation portion **51** which includes a radiation conductor **11** and a first ground conductor layer **13** spaced away from the radiation conductor **11** and having a first slot **13c,** and a power supply portion **52** which includes a strip conductor **14.** The strip conductor **14** has a first end portion **14c** which is supplied with an electric power from an external device and a second end portion **14d** which is spaced away from the first end portion in a longitudinal direction. The distance between the first end portion **14c** and the first ground conductor layer **13** is different from the distance between the second end portion **14d** and the first ground conductor layer **13.**

## Description

### TECHNICAL FIELD

The present disclosure relates to a planar array antenna and a wireless communication module.

### BACKGROUND ART

For high frequency wireless communication, a planar antenna is sometimes used. For example, Patent Documents Nos. 1 to 3 disclose planar antennas which have a slot in a conductor layer for power supply to a radiation conductor. Particularly, Patent Document No. 2 discloses a planar array antenna which includes a plurality of planar antennas. Specifically, Patent Document No. 2 discloses a planar array antenna which includes a plurality of strip conductors, a conductor layer with a plurality of slots, and a plurality of radiation conductors arranged so as to cover the respective slots.

### CITATION LIST

### PATENT LITERATURE

Patent Document No. 1: Japanese Laid-Open Patent Publication No. 2013-201712
Patent Document No. 2: Japanese Laid-Open Patent Publication No. 6-291536
Patent Document No. 3: Japanese Laid-Open Patent Publication No. 7-046033

### SUMMARY OF INVENTION

### TECHNICAL PROBLEM

Wireless communication has been applied to an increasing number of uses. Wireless communication has been utilized in various frequency bands. Thus, application to broader bands has been required. An object of the present application is to provide a planar array antenna which can be used in broader bands and a wireless communication module which includes the planar array antenna.

### SOLUTION TO PROBLEM

A planar array antenna of the present disclosure is a planar array antenna including a plurality of unit cells which are one-dimensionally or two-dimensionally arranged, each of the unit cells including a radiation portion which includes a radiation conductor and a first ground conductor layer spaced away from the radiation conductor and having a first slot, and a power supply portion which includes a strip conductor, wherein the strip conductor has a first end portion which is supplied with an electric power from an external device and a second end portion which is spaced away from the first end portion in a longitudinal direction, and a distance between the first end portion and the first ground conductor layer is different from a distance between the second end portion and the first ground conductor layer.

The power supply portion may include a second ground conductor layer spaced away from the strip conductor, the strip conductor being located between the first ground conductor layer and the second ground conductor layer.

In each of the unit cells, the radiation conductor and the first slot may be aligned in a layer stacking direction.

A longitudinal direction of the strip conductor may not be parallel to a longitudinal direction of the first slot.

A distance between the second end portion and the first ground conductor layer may be shorter than a distance between the first end portion and the first ground conductor layer.

The strip conductor may include a plurality of planar strip portions and at least one via conductor portion. The plurality of planar strip portions may be located between the first end portion and the second end portion such that a longitudinal direction of each of the planar strip portions is in accord with a longitudinal direction of the strip conductor, and at least one of opposite ends of each of the planar strip portions may be connected with one of opposite ends of an adjacent planar strip portion via one of the plurality of via conductor portions. In the strip conductor, one of two adjoining planar strip portions located on the second end portion side may be closer to the first ground conductor layer than the other planar strip portion which is on the first end portion side.

The plurality of planar strip portions may have equal widths in a direction perpendicular to the longitudinal direction.

In at least a pair of adjoining two of the plurality of planar strip portions, a width in a direction perpendicular to the longitudinal direction of the planar strip portion on the second end portion side may be greater than a width in a direction perpendicular to the longitudinal direction of the planar strip portion on the first end portion side.

A width of at least one of the plurality of planar strip portions may be greater on the second end portion side than on the first end portion side.

The plurality of planar strip portions may be arranged parallel to the first ground conductor layer.

The strip conductor may include a planar strip portion. A longitudinal direction of the planar strip portion may be in accord with the longitudinal direction of the strip conductor. One of opposite ends of the planar strip portion on the second end portion side may be closer to the first ground conductor layer than the other end on the first end portion side.

The radiation portion may be located between the radiation conductor and the first ground conductor layer so as to be spaced away from the radiation conductor and from the first ground conductor layer, the radiation portion further including a planar conductor layer which has a second slot.

In each of the unit cells, the radiation portion may include a plurality of the planar conductor layers.

The second slot may have the same shape as the first slot.

The second slot may have a different shape from the first slot.

A distance between the first ground conductor layer and the planar conductor layer may be not more than 50 µm.

The planar conductor layer may be electrically coupled with the first ground conductor layer or the second ground conductor layer.

The planar conductor layer may be a floating conductor layer.

The power supply portion of each of the unit cells may further include a plurality of via conductors. The plurality of via conductors may be connected with the first ground conductor layer and the second ground conductor layer and arranged so as to surround the strip conductor.

Each of the unit cells may include a multilayer ceramic structure, and at least the planar conductor layer, the first ground conductor layer, the second ground conductor layer and the strip conductor may be buried in the multilayer ceramic structure.

A wireless communication module of the present disclosure includes: the planar array antenna as set forth in any of the foregoing paragraphs; and an active part electrically coupled with the planar array antenna.

### ADVANTAGEOUS EFFECTS OF INVENTION

According to the present disclosure, a planar array antenna which can be used in broader bands can be realized.

### BRIEF DESCRIPTION OF DRAWINGS

FIG. **1** is a plan view showing the general configuration of planar array antennas of the first and second embodiments.
FIG. **2** is an exploded perspective view showing a configuration of a unit cell of the planar array antenna of the first embodiment.
FIG. **3** is a cross-sectional view showing a configuration of the unit cell of the planar array antenna of the first embodiment.
FIG. **4(a)** and FIG. **4(b)** are a plan view and a cross-sectional view showing an example of a strip conductor.
FIG. **5(a)** and FIG. **5(b)** are a plan view and a cross-sectional view showing another example of a strip conductor.
FIG. **6(a)** and FIG. **6(b)** are a plan view and a cross-sectional view showing another example of a strip conductor.
FIG. **7(a)** and FIG. **7(b)** are a plan view and a cross-sectional view showing another example of a strip conductor.
FIG. **8(a)** and FIG. **8(b)** are a plan view and a cross-sectional view showing another example of a strip conductor.
FIG. **9** is a top view showing the positional relationship of the respective components in a unit cell of the planar array antenna of the first embodiment.
FIG. **10** is an exploded perspective view showing a configuration of a unit cell of the planar array antenna of the second embodiment.
FIG. **11** is a cross-sectional view showing a configuration of the unit cell of the planar array antenna of the second embodiment.
FIG. **12** is a cross-sectional view showing another configuration of the unit cell of the planar array antenna of the second embodiment.
FIG. **13** is a top view showing the positional relationship of the respective components in a unit cell of the planar array antenna of the second embodiment.
FIG. **14** is a cross-sectional view showing an example where a planar array antenna is realized by a multilayer ceramic substrate.
FIG. **15** is a cross-sectional view showing another example where a planar array antenna is realized by a multilayer ceramic substrate.
FIG. **16** is a cross-sectional view showing a configuration example of a multilayer ceramic substrate which includes a wire circuit and a planar array antenna.
FIG. **17(a)** is a schematic bottom view showing an embodiment of a wireless communication module. FIG. **17(b)** is a schematic cross-sectional view showing a wireless communication module mounted to a substrate.
FIG. **18** is a diagram showing the dimensions of a structure used in a simulation of the characteristics of a planar array antenna of an inventive example.
FIG. **19** is a graph showing the VSWR characteristic of a planar array antenna of an inventive example which was determined by calculation.
FIG. **20** is a graph showing the radiation characteristic of a planar array antenna of an inventive example which was determined by calculation.
FIG. **21** is a graph showing the radiation characteristic of a planar array antenna of an inventive example which was determined by calculation.

### DESCRIPTION OF EMBODIMENTS

A planar array antenna and a wireless communication module of the present disclosure can be used for wireless communication in, for example, the quasi-microwave band, the centimeter wave band, the quasi-millimeter wave band and the millimeter wave band. The wireless communication in the quasi-microwave band uses as the carrier wave an electric wave which has a wavelength of 10 cm to 30 cm and a frequency of 1 GHz to 3 GHz. The wireless communication in the centimeter wave band uses as the carrier wave an electric wave which has a wavelength of 1 cm to 10 cm and a frequency of 3 GHz to 30 GHz. The wireless communication in the millimeter wave band uses as the carrier wave an electric wave which has a wavelength of 1 mm to 10 mm and a frequency of 30 GHz to 300 GHz. The wireless communication in the quasi-millimeter wave band uses as the carrier wave an electric wave which has a wavelength of 10 mm to 30 mm and a frequency of 10 GHz to 30 GHz. In the wireless communication in these bands, the size of the planar antenna is of the order of several centimeters to sub-millimeters. For example, if a quasi-microwave / centimeter wave / quasi-millimeter wave / millimeter wave wireless communication circuit is formed by a multilayer ceramic sintered substrate, a multiaxial antenna of the present disclosure can be mounted to the multilayer ceramic sintered substrate. Hereinafter, in the present embodiment, a planar array antenna is described with an example where the carrier wave of a quasi-microwave, centimeter wave, quasi-millimeter wave or millimeter wave has a frequency of 30 GHz and a wavelength λ of 10 mm unless otherwise specified.

In the present disclosure, if two directions are described as being "in accord", it means that the angle between the two directions is approximately in the range of 0° to about 45°. The term "parallel" means that the angle between two planes, the angle between two lines, or the angle between a plane and a line is in the range of 0° to about 10°.

### (FIRST EMBODIMENT)

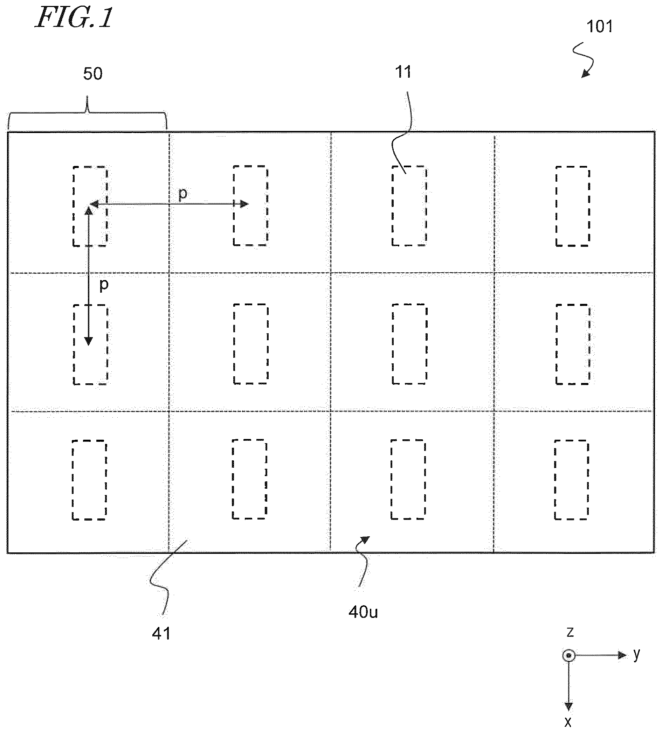

FIG. **1** is a plan view showing the first embodiment of a planar array antenna **101** of the present disclosure. The planar array antenna **101** includes a plurality of unit cells **50** which are represented by broken lines. Each of the unit cells **50** includes a radiation conductor **11** and forms a planar antenna which is capable of radiating an electromagnetic wave from the radiation conductor **11.** Each of the unit cells **50** is provided in a dielectric **41.** The plurality of unit cells **50** are one-dimensionally or two-dimensionally arranged at pitch **p.** In the present embodiment, as shown in FIG. **1****,** the plurality of unit cells **50** are two-dimensionally arranged in the x direction and the y direction. In the present embodiment, the radiation conductors **11** of the respective unit cells **50** are provided in the dielectric **41.** That is, at a predetermined depth from the upper surface **40u** of the dielectric **41,** the radiation conductors **11** are arranged in an array in the x direction and the y direction. The radiation conductors **11** of the respective unit cells **50** may be on the same plane or may be at different heights in the z-axis direction.

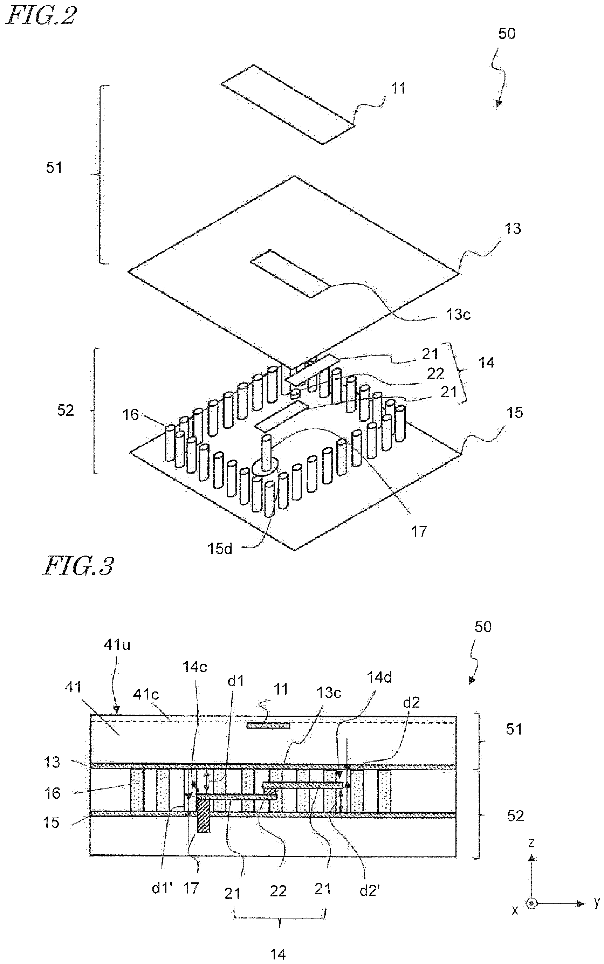

FIG. **2** is an exploded perspective view showing a configuration of the unit cell **50.** FIG. **3** is a cross-sectional view of the unit cell **50.** Each unit cell **50** includes a radiation portion **51** and a power supply portion **52.** The power supply portion **52** and the radiation portion **51** are electromagnetically coupled. The radiation portion **51** receives a signal power supplied from the power supply portion **52,** and an electromagnetic wave is radiated from the radiation conductor **11.**

The radiation portion **51** includes a radiation conductor **11** and a first ground conductor layer **13.** The radiation conductor **11** is spaced away from the first ground conductor layer **13.** The first ground conductor layer **13** has an opening, which is referred to as "the first slot **13c**".

The power supply portion **52** includes a strip conductor **14** and a second ground conductor layer **15.** The strip conductor **14** and the second ground conductor layer **15** are spaced away from each other. The strip conductor **14** is present between the first ground conductor layer **13** and the second ground conductor layer **15.** The first ground conductor layer **13** and the strip conductor **14** are also spaced away from each other in the layer stacking direction.

For power supply to the strip conductor **14,** the power supply portion **52** may include a via conductor **17.** In this case, the second ground conductor layer **15** has an opening **15d.** The via conductor **17** penetrates through the opening **15d,** and one end of the via conductor **17** is connected with the strip conductor **14.** The other end of the via conductor **17** is connected with a coupler, distributor, receiving circuit, transmitting circuit, or the like, on the lower surface side of the second ground conductor layer **15.**

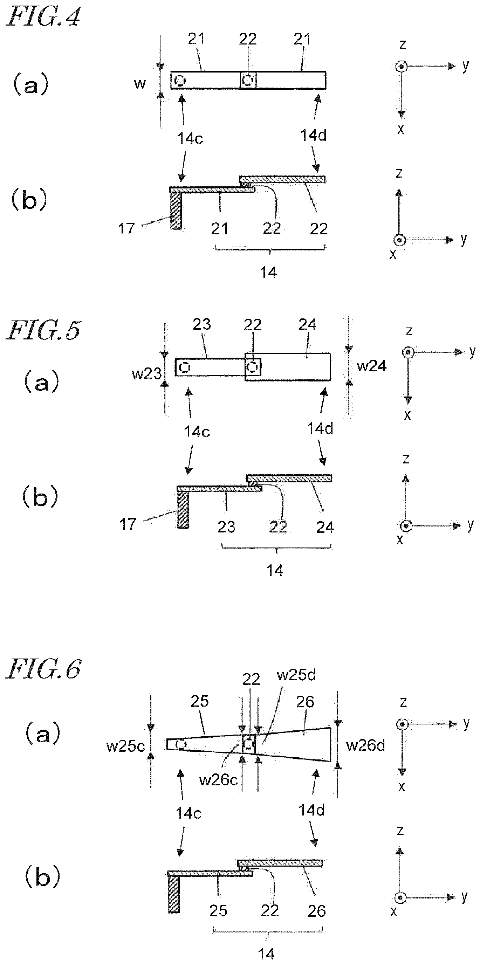

FIG. **4(a)** and FIG. **4(b)** are a plan view and a cross-sectional view of a strip conductor **14** to which a via conductor **17** is connected. The configuration of the strip conductor **14** is described with reference to FIG. **3** and FIG. **4****.**

The strip conductor **14** of the present embodiment has the longitudinal direction in the y direction in FIG. **3****.** The strip conductor **14** includes a first end portion **14c** and a second end portion **14d** which are at the opposite ends of the strip shape in the longitudinal direction. The second end portion **14d** is spaced away from the first end portion **14c.** Herein, the opposite ends and the end portions refer to portions in the vicinity of the opposite ends of a longitudinal member in the longitudinal direction. The first end portion **14c** is connected with the via conductor **17** and is supplied with a signal power from an external device. As shown in FIG. **3****,** in the strip conductor **14,** the distance **d1** between the first end portion **14c** and the first ground conductor layer **13** is different from the distance **d2** between the second end portion **14d** and the first ground conductor layer **13.**

In the present embodiment, the distance **d2** between the second end portion **14d** and the first ground conductor layer **13** is smaller than the distance **d1** between the first end portion **14c** and the first ground conductor layer **13.** That is, the relationship of **d1>d2** is satisfied. The distance between the strip conductor **14** that is for supply of a signal power from the power supply portion **52** to the radiation portion **51** and the first ground conductor layer **13** varies in the longitudinal direction, so that the gradient of the electromagnetic field in the dielectric space between the first ground conductor layer **13** and the second ground conductor layer **15** increases. Thus, a plurality of resonance modes are likely to occur, and the band of electromagnetic waves to be radiated is broadened.

As the electromagnetic field gradient between the first ground conductor layer **13** and the second ground conductor layer **15** increases, the gradient of the electromagnetic field distribution leaking from the first ground conductor layer **13** into the radiation conductor **11** increases. By optimizing these features and the shape of the radiation conductor **11,** impedance matching is more easily achieved, and a planar array antenna can be realized which is capable of radiating electromagnetic waves over a broad band.

Now, attention is given to the second ground conductor layer **15.** The distance **d2'** between the second end portion **14d** and the second ground conductor layer **15** is greater than the distance **d1'** between the first end portion **14c** and the second ground conductor layer **15.** That is, the relationship of **d1'<d2'** is satisfied. Also when the distance between the strip conductor **14** and the second ground conductor layer **15** varies in the longitudinal direction, an electric field distribution gradient occurs, and a plurality of resonance modes are more likely to occur. As a result, the band of electromagnetic waves to be radiated is broadened.

In the form shown in FIG. **3****,** the distance between the strip conductor **14** and the first ground conductor layer **13** decreases stepwise from the first end portion **14c** to the second end portion **14d.** So long as the distance of the strip conductor **14** from the first ground conductor layer **13** is different between the first end portion **14c** and the second end portion **14d,** the strip conductor **14** may have various forms and arrangements. For example, the strip conductor **14** may include a plurality of planar strip portions **21** and one or a plurality of via conductor portions **22.** The planar strip portions **21** have a length smaller than the overall length in the longitudinal direction of the strip conductor **14.** The planar strip portions **21** are provided between the first end portion **14c** and the second end portion **14d** such that the longitudinal direction of the planar strip portions **21** is in accord with the longitudinal direction of the strip conductor **14.** At least one of the opposite ends of each of the planar strip portions **21** is connected with one of the opposite ends of an adjacent planar strip portion **21** via the via conductor portion **22.** In the strip conductor **14,** one of adjoining two planar strip portions **21** on the second end portion **14d** side is closer to the first ground conductor layer **13** than the other planar strip portion **21** on the first end portion **14c** side. Each of the planar strip portions **21** is arranged parallel to the first ground conductor layer **13.** For example, the planar strip portions **21** are arranged stairlike when viewed in cross section.

In the form shown in FIG. **4(a)** and FIG. **4(b)****,** the widths **w** in a direction perpendicular to the longitudinal direction of the plurality of planar strip portions **21** are equal. However, the widths in a direction perpendicular to the longitudinal direction of the plurality of planar strip portions **21** may be different. For example, as shown in FIG. **5(a)** and FIG. **5(b)****,** the strip conductor **14** includes planar strip portions **23, 24** and a via conductor portion **22.** The planar strip portion **23** is located on the first end portion **14c** side. The planar strip portion **24** is located on the second end portion **14d** side. The width **w24** in a direction perpendicular to the longitudinal direction of the planar strip portion **24** is greater than the width **w23** in a direction perpendicular to the longitudinal direction of the planar strip portion **23.** In each of the planar strip portion **23** and the planar strip portion **24,** the width in a direction perpendicular to the longitudinal direction is constant. In this case, also in a plane parallel to the first ground conductor layer **13,** the electric field distribution gradient of a portion which includes the power supply portion **52** and the radiation portion **51** increases, and accordingly, a plurality of resonance modes are more likely to occur, and the band of electromagnetic waves to be radiated is broadened.

Alternatively, as shown in FIG. **6(a)** and FIG. **6(b)****,** the planar strip portions may have different widths in a direction perpendicular to the longitudinal direction. The strip conductor **14** includes planar strip portions **25, 26.** In the planar strip portion **25** and the planar strip portion **26,** the width **w25d, w26d** on the second end portion **14d** side is greater than the width **w25c, w26c** on the first end portion **14c** side.

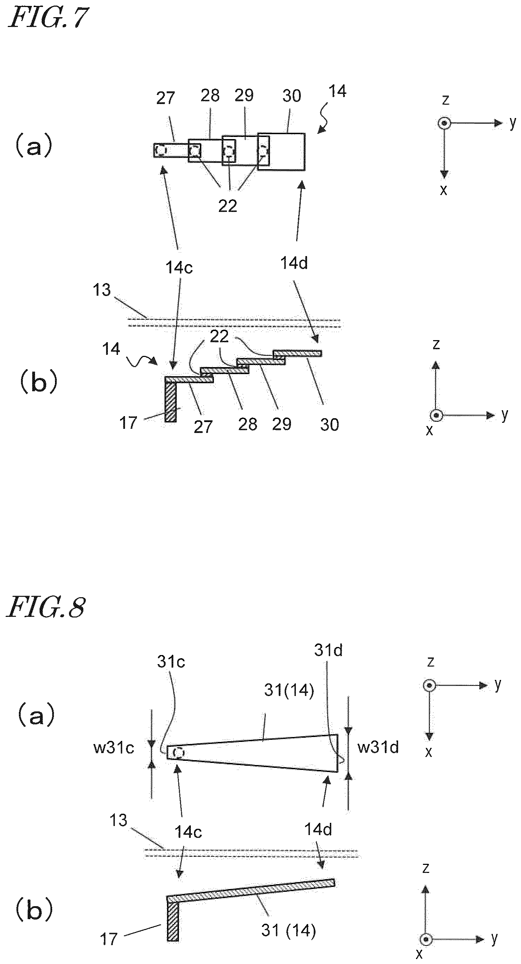

The number of planar strip portions included in the strip conductor **14** is not limited to two but may be three or more. As shown in FIG. **7(a)** and FIG. **7(b)**, the strip conductor **14** includes planar strip portions **27, 28, 29, 30** and three via conductor portions **22.** Each of the planar strip portions **27, 28, 29, 30** is, for example, arranged generally parallel to the first ground conductor layer **13.** The planar strip portion **30** is located closer to the first ground conductor layer **13,** represented by broken lines, than the planar strip portion **29.** Likewise, the planar strip portion **29** is located closer to the first ground conductor layer **13** than the planar strip portion **28,** and the planar strip portion **28** is located closer to the first ground conductor layer **13** than the planar strip portion **27.**

Alternatively, as shown in FIG. **8(a)** and FIG. **8(b)****,** the strip conductor **14** may include a single planar strip portion **31.** The longitudinal direction of the planar strip portion **31** is in accord with the longitudinal direction of the strip conductor **14.** One of the opposite ends of the planar strip portion **31** on the second end portion **14d** side, i.e., the end portion **31d,** is closer to the first ground conductor layer **13** (represented by broken lines) than the other end portion **31c** on the first end portion **14c** side. That is, the strip conductor **14** is not parallel to the first ground conductor layer **13** but is oblique with respect to the first ground conductor layer **13** in the longitudinal direction of the strip conductor **14.** In the planar strip portion **31,** the width **w31d** on the second end portion **14d** side is greater than the width **w31c** on the first end portion **14c** side in a direction perpendicular to the longitudinal direction.

The strip conductors **14** shown in FIG. **4** to FIG. **7** can be suitably incorporated into a multilayer ceramic substrate when the dielectric **41** is realized by a multilayer ceramic structure as will be described later. On the other hand, for example, when the dielectric **41** is made of a resin, the planar array antenna **101** that includes the strip conductor **14** shown in FIG. **8** can be suitably produced by molding or the like.

As shown in FIG. **2** and FIG. **3****,** in the present embodiment, the power supply portion **52** further includes a plurality of via conductors **16.** The via conductors **16** have a pole-like shape and are arranged so as to surround the strip conductor **14.** One end of each via conductor **16** is connected with the first ground conductor layer **13,** and the other end is connected with the second ground conductor layer **15.**

The radiation conductor **11,** the first ground conductor layer **13,** the strip conductor **14,** the second ground conductor layer **15,** the via conductors **16,** the via conductor **17** and the via conductors **18** (described later) are made of an electrically-conductive material.

As shown in FIG. **3****,** a plurality of dielectric layers which form the dielectric **41** are present between the radiation conductor **11,** the first ground conductor layer **13,** the strip conductor **14** and the second ground conductor layer **15.** The dielectric layers may be resin layers, glass layers, ceramic layers, cavities, etc. The radiation conductor **11,** the first ground conductor layer **13,** the strip conductor **14** and the second ground conductor layer **15** are buried in the dielectric **41.** As previously described, the radiation conductor **11** is present inside the dielectric **41** at a predetermined depth from the upper surface **40u** of the dielectric **41.** That is, the radiation conductor **11** is covered with part **(41c)** of the dielectric **41.** An example where the planar array antenna **101** is realized by a multilayer ceramic substrate will be described later.

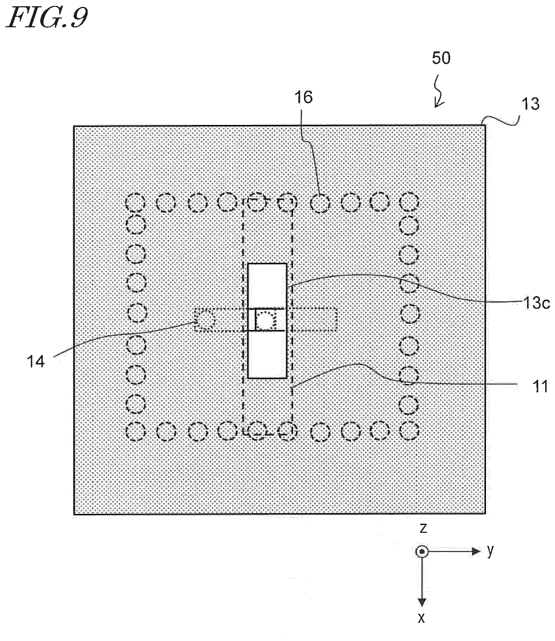

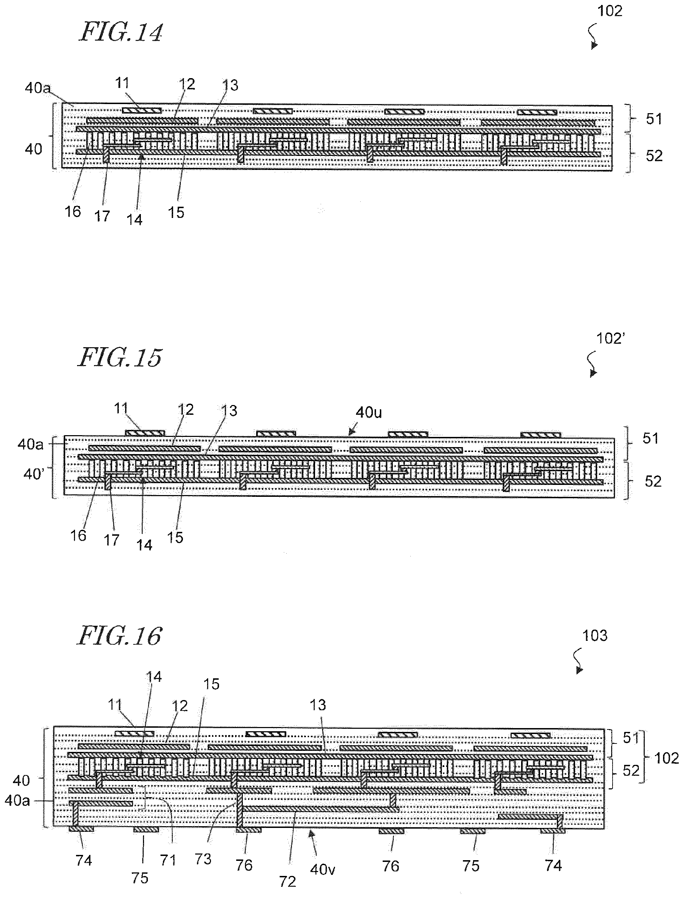

Next, the shape and arrangement of the respective components are described in detail. FIG. **9** is a schematic diagram of the respective structures of the unit cells **50** (see FIG. **1**), which is seen in a direction perpendicular to the upper surface **40u** of the multilayer ceramic structure **40** (see, for example, FIG. **15**), i.e., in a direction normal to the upper surface **40u.**

The radiation portion **51,** which includes the radiation conductor **11** and the first ground conductor layer **13,** is a radiation element which is capable of radiating an electric wave. The radiation portion **51** has a shape which is capable of achieving a required radiation characteristic and impedance matching. In the present embodiment, the radiation conductor **11** has a rectangular shape elongated in the x direction (which has a longitudinal dimension). The radiation conductor may have any other shape, such as square, circular, etc. For example, the radiation conductor **11** has lengths of 1.5 mm and 0.5 mm in the x direction and the y direction, respectively.

As shown in FIG. **1**, the pitch **p** of the radiation conductors **11** of the unit cells **50** is, for example, 1/2 of the wavelength λ₀ in the x direction and the y direction. Herein, λ₀ is the wavelength of the carrier wave in vacuum. λ_{d} is the wavelength of the carrier wave in the multilayer ceramic structure **40** that is a dielectric which will be described later.

The first slot **13c** of the first ground conductor layer **13** has, for example, a rectangular shape. For example, the first slot **13c** has lengths of 0.9 mm and 0.4 mm in the x direction and the y direction, respectively.

As shown in FIG. **9****,** the strip conductor **14** has, for example, a rectangular shape. The elongation direction of the strip conductor **14** and the elongation direction of the first slot **13c** are preferably transversal with each other.

The first ground conductor layer **13** and the second ground conductor layer **15** of each unit cell **50** are respectively connected with the first ground conductor layers **13** and the second ground conductor layers **15** of adjacent unit cells **50** and preferably form integral electrically-conductive layers.

The distance in the layer stacking direction between the first ground conductor layer **13** and the second ground conductor layer **15** is, for example, 0.25 mm. The strip conductor **14** is, for example, located at the midpoint between the first ground conductor layer **13** and the second ground conductor layer **15** in the layer stacking direction. The distance between the radiation conductor **11** and the first ground conductor layer **13** is, for example, 0.4 mm.

In the planar array antenna **101,** the signal power applied to a microstrip line which is formed by the strip conductor **14** and the second ground conductor layer **15** is electromagnetically coupled with the radiation conductor **11** via the first slot **13c** of the first ground conductor layer **13.** At this timing, the band of the radiated electromagnetic wave is broadened because the strip conductor **14** has the above-described configuration. Accordingly, the radiation characteristic and the signal reception characteristic of the planar array antenna **101** become broader.

If the strip conductor **14** is surrounded by the via conductors **16** at optimum positions, an electromagnetic field traveling in the y direction between the first ground conductor layer **13** and the second ground conductor layer **15** is likely to resonate, and the width in the x direction is optimized, so that impedance matching is more easily achieved, the radiation efficiency improves, and a broader band can be realized. When using a dielectric whose dielectric constant is not less than 1, the optimized structure size of each antenna can be smaller than the arrangement pitch of the unit cells. When employing the above-described configuration, a small-size planar antenna of high radiation efficiency over a broad band is realized.

In the planar array antenna **101** of the present embodiment, the radiation conductor **11** is provided in the dielectric **41.** Therefore, the radiation conductor **11** can be protected from oxidation which is attributed to external environments or damage or deformation which is attributed to external force.

From the viewpoint of protecting the radiation conductor **11,** providing the radiation conductor **11** on the upper surface **40u** of the dielectric **41** and forming an antioxidation plating layer over the radiation conductor **11** is a possible solution. However, in this case, the electrical conductivity of the radiation conductor **11** can decrease due to the plating layer, and the radiation characteristic can deteriorate. On the other hand, when the radiation conductor **11** is covered with the dielectric **41,** the electrical conductivity of the radiation conductor **11** does not decrease. Thus, while the radiation characteristic is maintained at a level equal to or greater than that achieved with the plating layer, the achieved protection effect, such as protection against external force, can be higher than that achieved with the plating layer.

The thickness of a layer **41c** of the dielectric **41** which covers the radiation conductor **11** is preferably not more than 70 µm when the relative permittivity of the dielectric **41** is, for example, about 3 to 15. The thickness of the layer **41c** is preferably not more than 20 µm when the relative permittivity of the dielectric **41** is about 5 to 10. In such a case, the achieved radiation efficiency can be equal to or higher than that achieved with an Au/Ni-plated radiation conductor **11** which is usually used in planar array antennas. As the thickness of the layer **41c** decreases, the loss is smaller. Therefore, the lower limit is not particularly determined from the viewpoint of the antenna characteristics. As will be described later, when the dielectric **41** is a multilayer ceramic structure, making uniform the thickness of the layer **41c** can be difficult if the thickness is excessively small. Thus, it is preferred that the thickness of the layer **41c** is, for example, 5 µm at which a uniform ceramic layer can be formed. That is, when the dielectric **41** is a multilayer ceramic structure, the thickness of the layer **41c** is more preferably not less than 5 µm and not more than 70 µm, still more preferably not less than 5 µm and less than 20 µm.

### (SECOND EMBODIMENT)

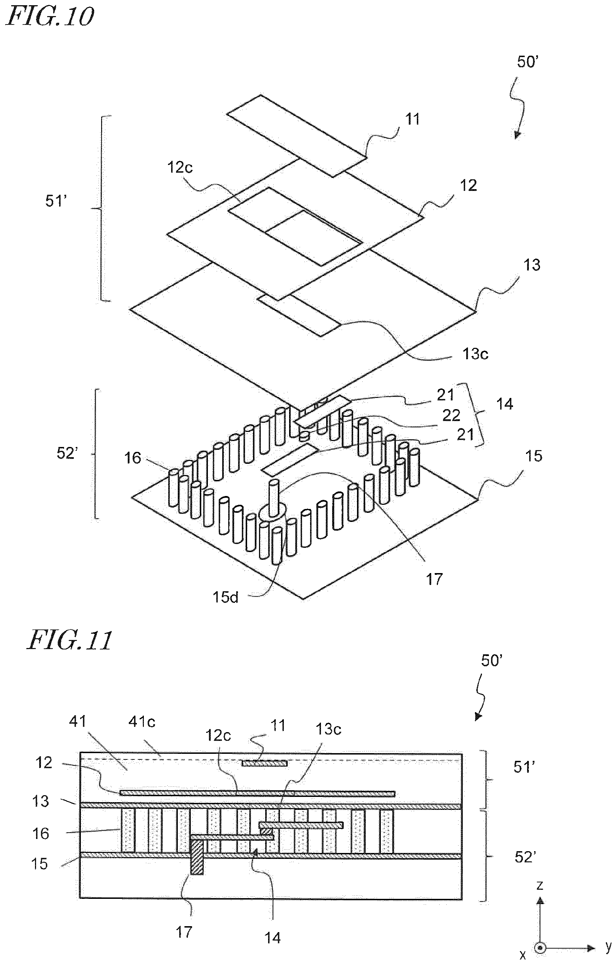

FIG. **10** and FIG. **11** are an exploded perspective view and a cross-sectional view of a unit cell **50**' in the second embodiment of the planar array antenna. The planar array antenna of the second embodiment is different from the unit cell **50** of the planar array antenna **101** of the first embodiment in that the radiation portion **51**' of the unit cell **50**' further includes a planar conductor layer **12.**

The radiation portion **51**' includes the planar conductor layer **12** located between the radiation conductor **11** and the first ground conductor layer **13.** The planar conductor layer **12** is spaced away from the radiation conductor **11** and from the first ground conductor layer **13** in the layer stacking direction. The planar conductor layer **12** has an opening, which is referred to as "the second slot **12c".**

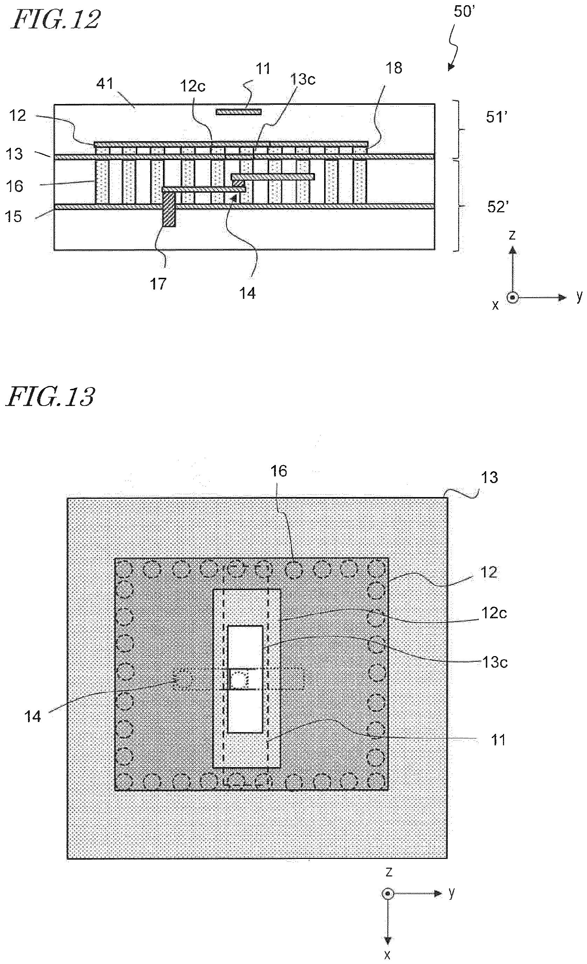

The planar conductor layer **12** in the present embodiment is a floating conductor layer. That is, the planar conductor layer **12** is not electrically coupled with the first ground conductor layer **13,** the second ground conductor layer **15,** or a conductor layer to which another reference potential is supplied. However, the planar conductor layer **12** may be grounded. Specifically, the planar conductor layer **12** may be electrically coupled with the first ground conductor layer **13,** the second ground conductor layer **15,** or a conductor layer to which another reference potential is supplied. For example, as shown in FIG. **12****,** the planar conductor layer **12** and the first ground conductor layer **13** may be coupled together by one or a plurality of via conductors **18.** The radiation portion **51**' may include a plurality of planar conductor layers **12.** The planar conductor layer **12** is made of an electrically-conductive material.

FIG. **13** is a schematic view of the respective components of the unit cell **50**' which are viewed in a direction perpendicular to the upper surface **40u** of the multilayer ceramic structure **40,** i.e., in a direction normal to the upper surface **40u.**

The radiation portion **51,** which includes the radiation conductor **11,** the planar conductor layer **12** and the first ground conductor layer **13,** is a radiation element which is capable of radiating an electric wave. The radiation portion **51** has a shape which is capable of achieving a required radiation characteristic and impedance matching.

The second slot **12c** of the planar conductor layer **12** may have the same shape as or may have a different shape from the first slot **13c** of the first ground conductor layer **13.** Herein, having the same shape does not include being similar but refers to being equal in shape and size (being congruent). Preferably, the radiation conductor **11,** the first slot **13c** and the second slot **12c** at least partially overlap one another when viewed from top. More preferably, the radiation conductor **11,** the first slot **13c** and the second slot **12c** are aligned in the layer stacking direction. Herein, being aligned means that the center of the first ground conductor layer **13,** the center of the first slot **13c** and the center of the second slot **12c** are within the tolerance in the x direction and the y direction when viewed in the layer stacking direction.

When each of the first slot **13c** and the second slot **12c** has a rectangular shape, the elongation directions (longitudinal directions) of the rectangles are preferably in accord with each other. For example, the first slot **13c** has lengths of 0.9 mm and 0.4 mm in the x direction and the y direction, respectively.

When the planar conductor layer **12** is a floating layer, the planar conductor layer **12** may be independent and not connected with the planar conductor layers **12** of adjacent unit cells **50**'. In this case, it is preferred that, when viewed from top, the planar conductor layer **12** covers a region in which the via conductors **16** surrounding the strip conductor **14** are provided.

When the planar conductor layer **12** is grounded, the planar conductor layer **12** may be connected with the planar conductor layers **12** of adjacent unit cells **50**' via unshown via conductors and/or wiring layers. Alternatively, the planar conductor layer **12** may form an integral electrically-conductive layer together with the planar conductor layers **12** of adjacent unit cells **50**' and may be coupled with the ground potential via via conductors and/or wiring layers.

The space between the planar conductor layer **12** and the first ground conductor layer **13** is preferably small. Specifically, the distance between the planar conductor layer **12** and the first ground conductor layer **13** is preferably not more than 50 µm, more preferably not more than 25 µm.

In the planar array antenna **101,** the signal power applied to a microstrip line which is formed by the strip conductor **14** and the second ground conductor layer **15** is electromagnetically coupled with the radiation conductor **11** via the first slot **13c** of the first ground conductor layer **13.** At this timing, due to the presence of the planar conductor layer **12,** complex resonance occurs between the radiation conductor **11** and the first ground conductor layer **13** that has the first slot **13c** and the planar conductor layer **12** that has the second slot **12c,** so that the band of the radiated electromagnetic wave becomes broader. Accordingly, the radiation characteristic and the signal reception characteristic of the planar array antenna **101** become still broader. Particularly, by shortening the distance between the planar conductor layer **12** and the first ground conductor layer **13,** equivalent electromagnetic fields are produced in the planar conductor layer **12** and the first ground conductor layer **13** from the strip conductor **14,** and thus, the effect of increasing the band width is easily achieved.

### (THIRD EMBODIMENT)

Hereinafter, an example where the planar array antenna of the first embodiment or the second embodiment is realized by a multilayer ceramic substrate is described. In the present embodiment, an example where the dielectric **41** of the planar array antenna of the second embodiment is realized by a multilayer ceramic structure is described. FIG. **14** schematically shows a cross section of a multilayer ceramic substrate **102.** The multilayer ceramic substrate **102** includes a multilayer ceramic structure **40,** and a radiation conductor **11,** a planar conductor layer **12,** a first ground conductor layer **13,** a strip conductor **14,** a second ground conductor layer **15,** via conductors **16** and via conductors **17** which are buried in the multilayer ceramic structure **40.**

The multilayer ceramic structure **40** includes a plurality of ceramic layers **40a** as represented by broken lines. The aforementioned components are spaced away from one another by one or two or more of the ceramic layers **40a.** The positions of the broken lines are schematically shown, and the number of ceramic layers **40a** included in the multilayer ceramic substrate is not necessarily precisely shown. The via conductors **16** and the via conductors **17** are present in the through holes in the ceramic layers **40a.**

The first slot **13c** and the second slot **12c** (see FIG. **10** and FIG. **13**) may be cavities or may be filled with part of the ceramic layers **40a.** When the first slot **13c** and the second slot **12c** are filled with part of the ceramic layers **40a,** the adhesion between the ceramic layers **40a** improves, and the strength of the multilayer ceramic structure **40** can be increased.

In the multilayer ceramic structure **40,** the boundaries between the ceramic layers **40a** can be indefinite. In this case, for example, when a non-ceramic component such as the first ground conductor layer **13** is present between two ceramic layers, the position of the first ground conductor layer **13** can be made corresponding to the boundary between the two ceramic layers. The ceramic layers **40a** may correspond to ceramic green sheets before sintering of the ceramic or may correspond to two or more layers of ceramic green sheets.

The thickness of each of the ceramic layers **40a** is for example not less than 1 µm and not more than 15 mm, preferably not less than 15 µm and not more than 1 mm. Thereby, a planar array antenna of quasi-microwave, centimeter wave, quasi-millimeter wave and millimeter wave bands can be constructed.

The radiation conductor **11** may be present on the upper surface of the multilayer ceramic structure. The multilayer ceramic substrate **102**' shown in FIG. **15** is different from the multilayer ceramic substrate **102** in that the radiation conductor **11** is present on the upper surface **40'u** of the multilayer ceramic structure **40**'. Since the radiation conductor **11** is exposed to the external environment, higher radiation efficiency can be realized. A product manufactured using a multilayer ceramic substrate of this configuration is suitable to a case where it is used under the conditions that damage or deformation which is attributed to, for example, environmental factors, such as temperature and humidity, or physical contact is unlikely to occur. More specifically, a product of this configuration is suitably used in a case where, for example, such conditions that it is encapsulated in vacuum or encapsulated in an inert gas when used or such conditions that a radiation conductor is formed using a metal which is unlikely to be corroded by oxidation or sulfidation are met.

The multilayer ceramic substrate may include other components than the planar array antenna **101.** For example, as shown in FIG. **16****,** the multilayer ceramic substrate **103** further includes a plurality of ceramic layers **40a** below the second ground conductor layer **15.** The multilayer ceramic substrate **103** further includes a passive-parts pattern **71,** a wiring pattern **72,** and an electrically-conductive via **73** provided in the plurality of ceramic layers **40a.** The passive-parts pattern **71** is, for example, an electrically-conductive layer or a ceramic layer which has a predetermined resistance value, and forms an inductor, capacitor, resistance, coupler, distributor, filter, power supply, etc. The electrically-conductive via **73** and the wiring pattern **72** are connected with the passive-parts pattern, the ground conductor, etc., to form a predetermined circuit.

On the lower surface **40v** of the multilayer ceramic structure **40,** for example, electrodes **74** for connection with an external substrate, electrodes **75** for connection of passive parts, and electrodes **76** for connection of active parts such as integrated circuit are provided. The strip conductor **14** may be electrically coupled with any of the electrodes **74, 75, 76** via an electrically-conductive via located at an unshown position.

The aforementioned components provided between the plurality of ceramic layers **40a** which are on the lower surface side than the second ground conductor layer **15** form a wire circuit which includes passive parts. The passive parts and integrated circuits are connected with the above-described electrodes of the wire circuit, whereby a wireless communication circuit is constructed.

When the planar array antenna **101** is realized by a multilayer ceramic substrate, it is possible to simultaneously fire respective ceramic layers and conductive layers including the radiation conductor **11** and the planar conductor layer **12.** That is, the multilayer ceramic substrate **103** may be a co-fired ceramic substrate. The co-fired ceramic substrate may be a low temperature co-fired ceramic (LTCC) substrate or may be a high temperature co-fired ceramic (HTCC) substrate. From the viewpoint of high frequency characteristics, using a low temperature co-fired ceramic substrate can be preferred. The ceramic materials and electrically-conductive materials which are used for ceramic layers, radiation conductors, ground conductors, strip conductors, passive-parts patterns, wiring patterns, electrically-conductive vias of the multilayer ceramic structure are selected according to the firing temperature, uses, and the frequency of wireless communication. An electrically-conductive paste for formation of radiation conductors, ground conductors (specifically, ground conductor layers), strip conductors, passive-parts patterns, wiring patterns and electrically-conductive vias, and green sheets for formation of ceramic layers of the multilayer ceramic structure are simultaneously fired (co-fired). When the co-fired ceramic substrate is a low temperature co-fired ceramic substrate, a ceramic material and an electrically-conductive material which can be sintered in a temperature range of about 800°C to about 1000°C are used. For example, a ceramic material which contains Al, Si and Sr as major constituents and at least one of Ti, Bi, Cu, Mn, Na and K as a minor constituent, a ceramic material which contains Al, Si and Sr as major constituents and at least one of Ca, Pb, Na and K as a minor constituent, a ceramic material which contains Al, Mg, Si and Gd, and a ceramic material which contains Al, Si, Zr and Mg can be used. An electrically-conductive material which contains Ag or Cu can be used. The dielectric constant of the ceramic material is about 3 to 15. When the co-fired ceramic substrate is a high temperature co-fired multilayer ceramic substrate, a ceramic material which contains Al as a major constituent and an electrically-conductive material which contains W (tungsten) or Mo (molybdenum) can be used.

More specifically, various materials can be used as the LTCC material. For example, an Al-Mg-Si-Gd-O based dielectric material of a low dielectric constant (relative permittivity: 5 to 10), a dielectric material consisting of a Mg₂SiO₄ crystalline phase and Si-Ba-La-B-O based glass, an Al-Si-Sr-O based dielectric material, an Al-Si-Ba-O based dielectric material, and a Bi-Ca-Nb-O based dielectric material of a high dielectric constant (relative permittivity: 50 or higher) can be used.

For example, when the Al-Si-Sr-O based dielectric material contains oxides of Al, Si, Sr and Ti as major constituents and the major constituents, Al, Si, Sr and Ti, are converted to Al₂O₃, SiO₂, SrO and TiO₂, the Al-Si-Sr-O based dielectric material preferably contains Al₂O₃: 10 to 60 mass%, SiO2: 25 to 60 mass%, SrO: 7.5 to 50 mass%, and TiO₂: not more than 20 mass% (including 0). The Al-Si-Sr-O based dielectric material preferably further contains at least one of the group consisting of Bi, Na, K and Co as a minor constituent in the range of 0.1 to 10 parts by mass when converted to Bi₂O₃, 0.1 to 5 parts by mass when converted to Na₂O, 0.1 to 5 parts by mass when converted to K₂O, 0.1 to 5 parts by mass when converted to CoO, with respect to 100 parts by mass of the major constituents. The Al-Si-Sr-O based dielectric material preferably further contains at least one of the group consisting of Cu, Mn and Ag in the range of 0.01 to 5 parts by mass when converted to CuO, 0.01 to 5 parts by mass when converted to Mn₃O₄, and Ag in the range of 0.01 to 5 parts by mass. In addition, the Al-Si-Sr-O based dielectric material can contain unavoidable impurities.

In the multilayer ceramic structure **40,** the plurality of ceramic layers **40a** may have the same composition and may be made of the same material. Alternatively, for the purpose of increasing the radiation efficiency of the planar antenna, a ceramic layer near the radiation conductor **11** of the multilayer ceramic structure **40** may have a different composition from that of the lower ceramic layers and may be made of a different material. When that layer has a different composition, the layer can have a different dielectric constant, and the radiation efficiency can be improved.

The radiation conductor **11** may be covered with a resin or glass layer other than the ceramic layers. Alternatively, the multilayer ceramic structure **40** and a circuit board which is made of a resin or glass may be combined to construct a complex substrate.

The co-fired ceramic substrate can be produced by the same production method as that used for LTCC substrates or HTCC substrates.

For example, firstly, a ceramic material which contains the above-described elements is prepared and, when necessary, calcinated at for example 700°C to 850°C and pulverized into grains. Glass powder, an organic binder, a plasticizer and a solvent are added to the ceramic material, resulting in a slurry of the mixture of these materials. When the ceramic layers are made of different materials for the purpose of for example achieving different dielectric constants, two types of slurries which contain different materials are prepared. Powder of the above-described electrically-conductive material is mixed with an organic binder and a solvent, resulting in an electrically-conductive paste.

A slurry layer of a predetermined thickness is formed on a carrier film using a doctor blade method, a rolling (extrusion) method, a printing method, an ink jet coating method, a transfer method, or the like, and then dried. The resultant slurry layer is cut into ceramic green sheets.

Then, according to the circuits which are to be constructed in the co-fired ceramic substrate, via holes are formed in a plurality of ceramic green sheets using laser, mechanical puncher, or the like, and the respective via holes are filled with an electrically-conductive paste by a screen printing method. In this step, the pattern of the via conductors **16** and the via conductors **17** is also formed. An electrically-conductive paste is printed on the ceramic green sheets by screen printing, whereby a wiring pattern, a passive-parts pattern, and a pattern of the radiation conductor **11,** the planar conductor layer **12,** the first ground conductor layer **13,** the strip conductor **14** and the second ground conductor layer **15** are formed in the ceramic green sheets.

The ceramic green sheets to which the above-described electrically-conductive paste is provided are sequentially stacked up while being preparatorily pressure-bonded, whereby a green sheet multilayer structure is formed. Thereafter, the binder is removed from the green sheet multilayer structure, and the resultant green sheet multilayer structure from which the binder has been removed is baked, whereby a co-fired ceramic substrate is completed.

The thus-produced co-fired ceramic substrate includes a wire circuit for wireless communication, passive parts, and a planar array antenna. Therefore, by mounting a chip set for wireless communication to a co-fired ceramic substrate, a wireless communication module which also includes an antenna is realized.

When the ceramic layer at the surface of the multilayer ceramic structure entirely covers the radiation conductor, the ceramic layer can protect the radiation conductor from the external environment and external force and can prevent the radiation efficiency from decreasing and the antenna properties from varying.

In the planar array antenna described in the present embodiment, the shape, number and arrangement of the radiation conductors, the planar conductor layer, the first ground conductor layer, the second ground conductor layer and the strip conductors are merely schematic examples. For example, some of the plurality of radiation conductors may be provided at the interface of ceramic layers located at different distances from the ground conductor. The radiation conductors may have a slot. The planar array antenna may include conductors to which the power is not to be supplied in addition to the radiation conductors. Such conductors may be stacked up with the radiation conductors and ceramic layers being interposed therebetween.

### (FOURTH EMBODIMENT)

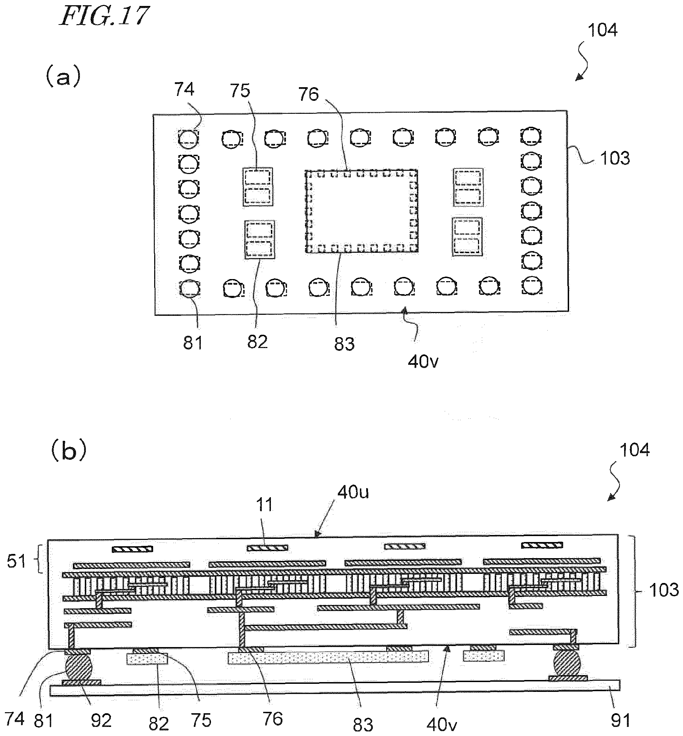

An embodiment of a wireless communication module is described. FIG. **17(a)** is a schematic bottom view showing an embodiment of a wireless communication module of the present disclosure. FIG. **17(b)** is a schematic cross-sectional view showing a wireless communication module mounted to a substrate. The wireless communication module **104** includes the multilayer ceramic substrate **103** of the second embodiment, solder bumps **81,** a passive part **82** and an active part **83.** The solder bumps **81** are provided on electrodes **74** which are located at the lower surface **40v** of the multilayer ceramic substrate **103.** The passive part **82** is, for example, a chip capacitor, a chip inductor, a chip resistor, or the like, and is bonded to an electrode **75** by soldering or the like. The active part **83** is, for example, a chip set for wireless communication, which is a receiving circuit, transmitting circuit, A/D converter, D/A converter, baseband processor, media access controller, or the like, and is bonded to an electrode **76** by soldering or the like.

The wireless communication module **104** is, for example, bonded face down to a circuit board **91** which has an electrode **92** by flip chip bonding, i.e., such that the passive part **82** and the active part **83** face the circuit board **91.** The electrodes **92** of the circuit board **91** are electrically coupled with the electrodes **74** of the multilayer ceramic substrate **103** via the solder bumps **81,** whereby the multilayer ceramic substrate **103** is electrically coupled with an external power supply circuit or other modules.

In the wireless communication module **104** mounted to the circuit board **91,** the radiation conductor **11** on the upper surface **40u** side of the multilayer ceramic substrate **103** is located opposite to the lower surface **40v** on which the circuit board **91** faces. Therefore, the wireless communication module **104** is capable of radiating electric waves in quasi-microwave, centimeter wave, quasi-millimeter wave and millimeter wave bands from the radiation portion **51** without being affected by the passive part **82** and the active part **83** or by the circuit board **91** and is capable of receiving at the radiation portion **51** incoming electric waves in quasi-microwave, centimeter wave, quasi-millimeter wave and millimeter wave bands. Thus, a wireless communication module can be realized which has a broad band antenna, which is small in size, and which is capable of surface mounting.

### (Example of Calculation of Characteristic of Planar Array Antenna)

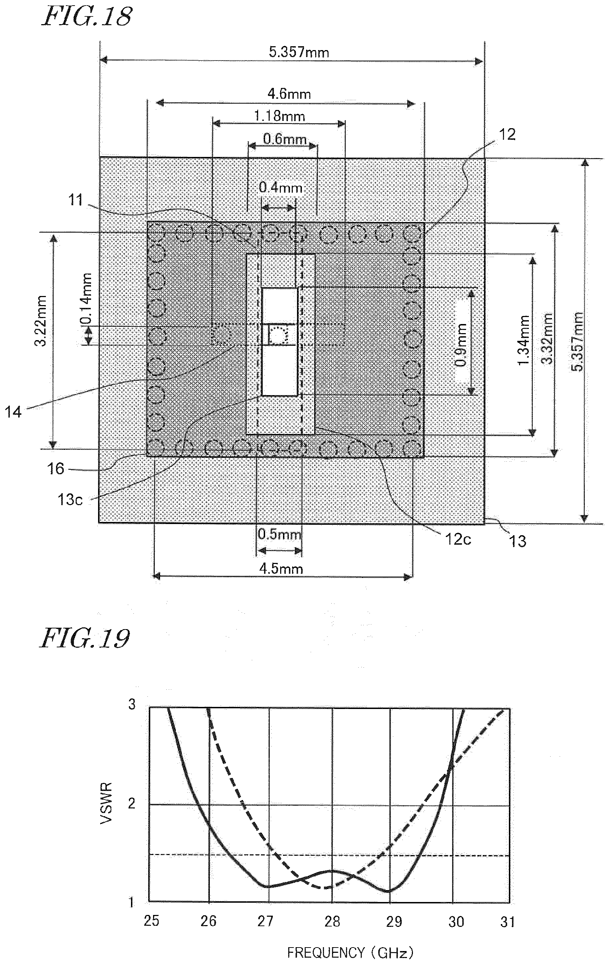

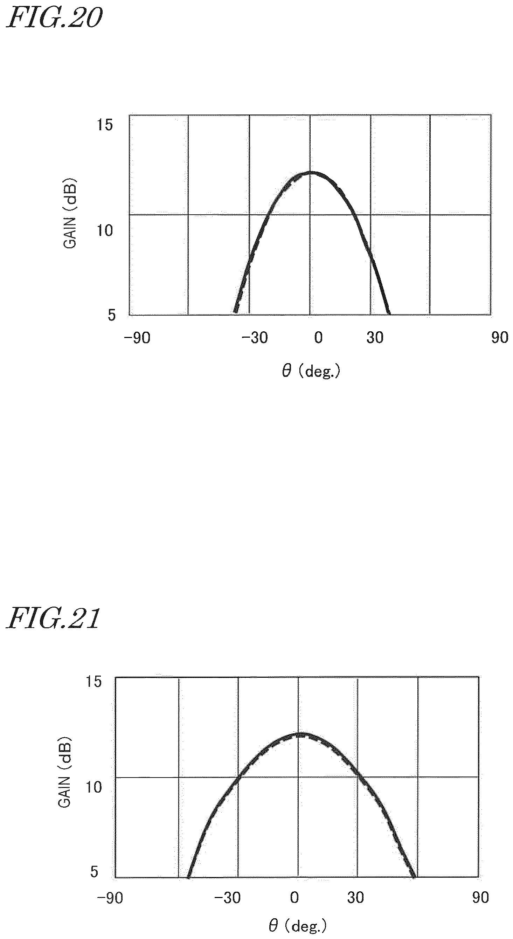

The results of calculation of a characteristic of the planar array antenna of the second embodiment are described. The s parameter was measured according to the size and physical properties shown in FIG. **18** and TABLE 1. The VSWR characteristic is shown in FIG. **19****.** The radiation characteristic of the planar array antenna is shown in FIG. **20** and FIG. **21****.** For the sake of reference, the characteristic of a planar array antenna in which the distances between the opposite end portions of the strip conductor **14** and the first ground conductor layer **13** are equal is determined and shown in these graphs. In FIG. **19** through FIG. **21****,** solid lines represent the characteristic of the inventive example while broken lines represent the characteristic of the reference example.

**[TABLE 1]**

| PROPERTIES | VALUES |
|---|---|
| dielectric constant | 6 |
| tanδ | 0.0018 |
| material and size of electrode | Ag, 12 µm, 4 µm |
| pitch of unit cells | x: 5.357 mm, y: 5.357 mm |
| number of unit cells | 6 (3×2) |

As shown in FIG. **19****,** for example, in the reference example, VSWR is not more than 1.5 when the frequency is from about 27.2 GHz to about 28.8 GHz, while in the inventive example, VSWR is not more than 1.5 when the frequency is from about 26.4 GHz to about 29.5 GHz. According to the planar antenna of the second embodiment, it can be seen that an electromagnetic wave can be transmitted while reflection is suppressed in a broad band.

FIG. **20** and FIG. **21** show the gain characteristic of an electromagnetic wave radiated from the planar array antenna of Inventive Example 1. FIG. **20** and FIG. **21** show the characteristic in the xz plane and the characteristic in the yz plane, respectively, where the coordinate system is set as shown in FIG. **1****.** The z axis, i.e., the normal direction of the upper surface **40u,** is 0°. The +x axis and -x axis directions or the +y axis and -y axis directions correspond to +90° and -90° of θ.

It can be seen from these graphs that, in the planar antenna of the inventive example, the gain was the same in some portions of the range shown in the graphs but the gain improved by about 0.2 dB in other portions of the range, and on average, the gain improved as compared with the reference example.

Thus, it can be seen from these calculation results that the planar antenna of the inventive example is capable of transmitting and receiving electromagnetic waves in broad bands and improving the gain.

### REFERENCE SIGNS LIST

- **11**: radiation conductor
- **12**: planar conductor layer
- **12c**: second slot
- **13**: first ground conductor layer
- **13c**: first slot
- **14**: strip conductor
- **14c**: first end portion
- **14d**: second end portion
- **15**: second ground conductor layer
- **15d**: opening
- **16, 17, 18**: via conductor
- **22**: via conductor portion
- **21** to **31**: planar strip portion
- **40, 40'**: multilayer ceramic structure
- **40a, 40b, 40e**: ceramic layer
- **40u, 40'u**: upper surface
- **40v**: lower surface
- **41**: dielectric
- **41c**: dielectric layer
- **50, 50'**: unit cell
- **51, 51'**: radiation portion
- **52, 52'**: power supply portion
- **71**: passive-parts pattern
- **72**: wiring pattern
- **73**: electrically-conductive via
- **74** to **76, 92**: electrode
- **81**: solder bump
- **82**: passive part
- **83**: active part
- **91**: circuit board
- **101**: planar array antenna
- **102, 102', 103**: multilayer ceramic substrate
- **104**: wireless communication module

## Claims

1. A planar array antenna comprising a plurality of unit cells which are one-dimensionally or two-dimensionally arranged, each of the unit cells including
a radiation portion which includes a radiation conductor and a first ground conductor layer spaced away from the radiation conductor and having a first slot, and
a power supply portion which includes a strip conductor, wherein the strip conductor has a first end portion which is supplied with an electric power from an external device and a second end portion which is spaced away from the first end portion in a longitudinal direction, and
a distance between the first end portion and the first ground conductor layer is different from a distance between the second end portion and the first ground conductor layer.

2. The planar array antenna of claim 1, wherein the power supply portion includes a second ground conductor layer spaced away from the strip conductor, the strip conductor being located between the first ground conductor layer and the second ground conductor layer.

3. The planar array antenna of claim 2 wherein, in each of the unit cells, the radiation conductor and the first slot are aligned in a layer stacking direction.

4. The planar array antenna of claim 2 or 3, wherein a longitudinal direction of the strip conductor and a longitudinal direction of the first slot are transversal with each other.

5. The planar array antenna of any of claims 2 to 4, wherein a distance between the second end portion and the first ground conductor layer is shorter than a distance between the first end portion and the first ground conductor layer.

6. The planar array antenna of claim 5, wherein
the strip conductor includes a plurality of planar strip portions and at least one via conductor portion,
the plurality of planar strip portions are located between the first end portion and the second end portion such that a longitudinal direction of each of the planar strip portions is in accord with a longitudinal direction of the strip conductor, and at least one of opposite ends of each of the planar strip portions is connected with one of opposite ends of an adjacent planar strip portion via one of the plurality of via conductor portions, and
in the strip conductor, one of two adjoining planar strip portions located on the second end portion side is closer to the first ground conductor layer than the other planar strip portion which is on the first end portion side.

7. The planar array antenna of claim 6, wherein the plurality of planar strip portions have equal widths in a direction perpendicular to the longitudinal direction.

8. The planar array antenna of claim 6 wherein, in at least a pair of adjoining two of the plurality of planar strip portions, a width in a direction perpendicular to the longitudinal direction of the planar strip portion on the second end portion side is greater than a width in a direction perpendicular to the longitudinal direction of the planar strip portion on the first end portion side.

9. The planar array antenna of claim 6, wherein a width of at least one of the plurality of planar strip portions is greater on the second end portion side than on the first end portion side.

10. The planar array antenna of claim 6, wherein the plurality of planar strip portions are arranged parallel to the first ground conductor layer.

11. The planar array antenna of claim 5, wherein
the strip conductor includes a planar strip portion,
a longitudinal direction of the planar strip portion is in accord with the longitudinal direction of the strip conductor, and
one of opposite ends of the planar strip portion on the second end portion side is closer to the first ground conductor layer than the other end on the first end portion side.

12. The planar array antenna of any of claims 2 to 11, wherein the radiation portion is located between the radiation conductor and the first ground conductor layer so as to be spaced away from the radiation conductor and from the first ground conductor layer, the radiation portion further including a planar conductor layer which has a second slot.

13. The planar array antenna of claim 12 wherein, in each of the unit cells, the radiation portion includes a plurality of the planar conductor layers.

14. The planar array antenna of claim 12 or 13, wherein the second slot has the same shape as the first slot.

15. The planar array antenna of claim 12 or 13, wherein the second slot has a different shape from the first slot.

16. The planar array antenna of any of claims 12 to 15, wherein a distance between the first ground conductor layer and the planar conductor layer is not more than 50 µm.

17. The planar array antenna of any of claims 12 to 16, wherein the planar conductor layer is electrically coupled with the first ground conductor layer or the second ground conductor layer.

18. The planar array antenna of any of claims 12 to 16, wherein the planar conductor layer is a floating conductor layer.

19. The planar array antenna of any of claims 2 to 18, wherein
the power supply portion of each of the unit cells further includes a plurality of via conductors, and
the plurality of via conductors are connected with the first ground conductor layer and the second ground conductor layer and arranged so as to surround the strip conductor.

20. The planar array antenna of any of claims 2 to 19, wherein each of the unit cells includes a multilayer ceramic structure, and at least the planar conductor layer, the first ground conductor layer, the second ground conductor layer and the strip conductor are buried in the multilayer ceramic structure.

21. A wireless communication module comprising:
the planar array antenna as set forth in claim 20; and
an active part electrically coupled with the planar array antenna.
